# EUROPÄISCHE PATENTSCHRIFT

(11) **EP 2 916 414 B1**
(45) Veröffentlichungstag und Bekanntmachung des Hinweises auf die Patenterteilung: **07.12.2016**
(21) Anmeldenummer: 14165242.0
(22) Anmeldetag: 17.04.2014
(51) Int. Cl.: H02H 5/10, G01R 31/02

(54) **Überwachungsmodul zur Schutzleiterüberwachung**
Monitoring module for monitoring a protective conductor
Module de surveillance destiné à la surveillance de conducteur de mise à la terre

(30) Priorität: 28.02.2014 DE 202014100930 U; 18.03.2014 DE 202014101250 U
(43) Veröffentlichungstag der Anmeldung: 09.09.2015
(73) Patentinhaber: Pöllet, Wilfried, 90596 Schwanstetten (DE)
(72) Erfinder: Pöllet, Wilfried, 90596 Schwanstetten (DE)
(74) Vertreter: FDST Patentanwälte

(56) Entgegenhaltungen:
- EP-A1- 2 626 965
- DE-A1-102004 004 891
- DE-A1-102013 017 252
- US-A1- 2004 024 545
- US-B2- 8 125 345

## Beschreibung

Die Erfindung betrifft ein Überwachungsmodul zur Schutzleiterüberwachung, umfassend eine Überwachungsschaltung zur Überwachung, ob ein Schutzleiter ordnungsgemäß angeschlossen ist, wobei die Überwachungsschaltung bei der Detektion einer Schutzleiterunterbrechung dies als einen ersten Fehlerfall identifiziert und ein erstes Fehlersignal ausgibt.

Ein derartiges Überwachungsmodul ist beispielsweise in der EP 0 778 467 A2 beschrieben. Die daraus zu entnehmende Schaltungsanordnung umfasst einen Phasenanschluss für einen Phasenleiter, einen Nullanschluss für einen Nullleiter sowie einen PE-Anschluss für einen zu überwachenden Schutzleiter. Der Phasenanschluss sowie der Nullanschluss sind über einen kapazitiven Spannungsteiler miteinander verbunden. An dessen Mittenabgriff ist einerseits der PE-Anschluss und zum anderen einer Auswerteschaltung angeschlossen, über die der an diesem Mittenabgriff anliegende Spannungswert abgegriffen und ausgewertet wird. Die abgegriffene PE-Spannung wird mit Hilfe eines Komparators mit dem vorgegebenen Schwellwert verglichen. Für den Fall eines ordnungsgemäßen Anschlusses des Schutzleiters liegen der PE-Anschluss sowie der Nullanschluss üblicherweise auf dem zumindest annähernd gleichen Erdpotenzial, so dass die am Mittenabgriff anliegende PE-Spannung sehr gering und unterhalb des Schwellwerts liegt. Für den Fall eines nicht ordnungsgemäß angeschlossenen Schutzleiters, wenn dieser also unterbrochen ist, liegt demgegenüber an dem Mittengriff aufgrund der Spannungsteilerfunktion ein deutlich höherer Spannungswert für die PE-Spannungen, was über den Komparator als Fehlerfall identifiziert wird, da dann der eingestellte Schwellwert überschritten wird.

In diesem Fall kann dann ein Alarmsignal ausgegeben werden. Diese Schaltungsanordnung dient allgemein zum Schutz für gefährliche Körperströme, da rechtzeitig erkannt wird, ob ein Schutzleiter ordnungsgemäß angeschlossen ist.

Die in der EP 0 787 467 A2 beschriebene Schaltungsanordnung dient dabei insbesondere zur Überwachung eines elektrisch betriebenen Sprudelbades.

Aus der EP 2 626 965 A1 ist eine weitere Überwachungsschaltung zur Schutzleiter-Überwachung zu entnehmen. Diese dient zur Integration in einer Stromleitungsverlängerung, wie beispielsweise eine Kabeltrommel, um überprüfen zu können, ob der Schutzleiter ordnungsgemäß mit Erdpotenzial verbunden ist. Bei dieser Schaltung wird überprüft, ob über den Schutzleiteranschluss (PE-Anschluss) ein Strom fließt. Hierbei wird davon ausgegangen, dass bei korrektem Anschluss in jedem Betriebszustand zumindest ein geringer Strom über den Schutzleiter abfließt, der dann messbar ist. Ist der Schutzleiter unterbrochen, fließt demnach kein Strom mehr. Neben der Ausgabe eines akustischen oder optischen Alarmsignals ist gemäß der EP 2626965 A1 auch ein Abschalten der Stromversorgung vorgesehen.

Ausgehend hiervon liegt der Erfindung die Aufgabe zugrunde, ein verbessertes Überwachungsmodul zur Schutzleiter-Überwachung anzugeben.

Die Aufgabe wird erfindungsgemäß gelöst durch ein Überwachungsmodul mit den Merkmalen des Anspruchs 1. Bevorzugte Ausgestaltungen und Weiterbildungen sind in den weiteren Unteransprüchen enthalten.

Das erfindungsgemäße Überwachungsmodul weist zur Überwachung, ob ein Schutzleiter ordnungsgemäß angeschlossen ist, eine Überwachungsschaltung auf, welche bei der Detektion einer Schutzleiterunterbrechung die als einen ersten Fehlerfall identifiziert und ein erstes Fehlersignal ausgibt. Unter einem ordnungsgemäß angeschlossenen Schutzleiter wird allgemein verstanden, dass ein Schutzleiter eines Stromversorgungsnetzes mit Erdpotenzial verbunden ist. Bei Installationsnetzen von Gebäuden sind der Schutzleiter und der Nullleiter üblicherweise installationseingangsseitig, also bei einem Versorgungseingang für das gesamte Gebäude, elektrisch miteinander verbunden, so dass der Schutzleiter und der Nullleiter üblicherweise auf einem zumindest annähernd gleichen Potenzial liegen.

Ist der Schutzleiter nicht ordnungsgemäß angeschlossen, ist daher keine elektrische Verbindung mit dem Erdpotenzial mehr vorhanden.

Das Überwachungsmodul ist weiterhin zur Speicherung des ersten Fehlerfalls ausgebildet und zwar derart, dass im Falle einer nur temporären, nicht mehr vorliegenden Schutzleiterunterbrechung dies als ein zweiter temporärer Fehlerfall identifiziert und ein zweites Fehlersignal ausgegeben wird, weiches vom ersten Fehlersignal verschieden ist. Vorzugsweise handelt es sich bei dem zweiten Fehlersignal dabei um ein kombiniertes Fehlersignal, welches sowohl einen aktuellen ordnungsgemäßen Zustand anzeigt sowie weiterhin anzeigt, dass ein erster Fehlerfall vorgelegen hat. Weiterhin ist vorgesehen, dass im ordnungsgemäßen Zustand ein Signal ausgegeben wird, welches diesen ordnungsgemäßen Zustand anzeigt, insbesondere eine beispielsweise grün leuchtende Signallampe. Ergänzend ist zur Anzeige des zweiten temporären Fehlerfalls eine weitere Signalleuchte, beispielsweise eine orange oder rote Leuchte aktiviert.

Ein entscheidender Gesichtspunkt bei dieser Ausgestaltung ist darin zu sehen, dass eine Speicherung im Falle des Auftretens eines Fehlerfalls erfolgt und dass bei Wegfall des ersten Fehlerfalls quasi zwei Betriebszustände angezeigt werden, nämlich der aktuelle i.0.-Zustand sowie der in der Vergangenheit liegende fehlerhafte Zustand. Diese Ausgestaltung beruht auf der Überlegung, dass in bestimmten Anwendungsfällen das Problem besteht, dass eine Schutzleiterunterbrechung beispielsweise durch einen Wackelkontakt herbeigeführt wird, so dass der Schutzleiter immer wieder unterbrochen bzw. mit Erdpotenzial verbunden ist. Bei diesem Zustand handelt es sich dabei auch um einen Fehler, da nicht die permanent ordnungsgemäße Verbindung mit dem Erdpotenzial sichergestellt ist.

Grundsätzlich ist das Überwachungsmodul zur permanenten, dauernden Überwachung ausgebildet, braucht also für die Überwachungsfunktion nicht extra aktiviert zu werden. Dadurch ist gewährleistet, dass zuverlässig auch temporäre Störungen erfasst werden.

Insbesondere bei variablen Elektrifizierungssystemen, bei denen einzelne Schreibtische mit Steckdosenleistungssystemen versorgt werden, ist dies von besonderer Bedeutung. Hier treten nämlich häufig Probleme auf, dass die Kabel beispielsweise am Boden verlegt werden, über die dann wiederholt Bürostühle verfahren, was zum Leitungsbruch führen kann. Auch tritt häufig das Problem auf, da Kabel eingeklemmt werden etc. Grundsätzlich ist in solchen Fällen durch die erfindungsgemäßen Überwachungsmodule sichergestellt, dass der Benutzer einen Alarmhinweis bekommt, dass ein Problem mit dem Schutzleiter zumindest temporär bestanden hat.

Zweckdienlicherweise ist hierbei weiterhin vorgesehen, dass die Überwachungsschaltung derart ausgebildet ist, dass dieser temporäre Fehlerfall dauerhaft bis zu einem manuellen Reset gespeichert bleibt. Es bedarf daher eines bewussten aktiven Abschaltens des Fehlerfalls, was zusätzlich zur Sicherheit beiträgt. Der entsprechende Speicher ist daher für eine dauerhafte Speicherung des temporären Fehlerfalls ausgebildet. Der manuelle Reset erfolgt beispielsweise durch eine Unterbrechung der Versorgungsspannung für das Überwachungsmodul.

Im Hinblick auf eine effiziente Überwachung mit vielfältigen Funktionen, insbesondere auch der Speicherfunktion, ist die Überwachungsschaltung mit einem Microcontroller versehen, welcher zumindest den ersten Fehlerfall identifiziert. Ergänzend ist der Microcontroller auch zur Speicherung des ersten Fehlerfalls im Falle eines temporären Fehlerfalls ausgebildet. Der Microcontroller ist dabei insbesondere zur Spannungsauswertung von eingangsseitig an ihm anliegenden Spannungswerten ausgebildet.

Die Überwachungsschaltung ist dabei insbesondere zur Auswertung einer an einem PE-Anschluss anliegenden PE-Spannung ausgebildet. Anhand des Spannungswertes der PE-Spannung werden die unterschiedlichen nachfolgend noch beschriebenen Fehlerfälle identifiziert.

Insgesamt weist die Überwachungsschaltung hierzu eingangsseitig einen Phasenanschluss für einen Phasenleiter mit einem sich daran anschließenden Phasenpfad, einen PE-Anschluss für den zu überwachenden Schutzleiter mit einem sich daran anschließenden PE-Pfad sowie einen Nullanschluss für einen Nullleiter mit einem sich daran anschließenden Nullpfad auf. Zur Überprüfung einer am PE-Pfad anliegenden PE-Spannung im Hinblick auf das Vorliegen zumindest des ersten Fehlerfalls weist die Überwachungsschaltung weiterhin eine Auswerteeinheit auf, insbesondere den erwähnten Microcontroller. Diese Auswerteeinheit weist einen PE-Eingang auf und ist dazu ausgebildet, die PE-Spannung mit einem ersten Spannungsreferenzwert zu vergleichen.

Zweckdienlicherweise wird die PE-Spannung dabei an einem Mittenabgriff eines zwischen dem Phasenpfad und dem Nullpfad ausgebildeten Spannungsteiler abgegriffen und als PE-Spannung ausgewertet. Insoweit ist die Überwachungsschaltung ähnlich der Schaltung ausgebildet, wie sie in der EP 0 778 467 A2 beschrieben wird. Ein wesentlicher Unterschied ist bereits darin zu sehen, dass bei der erfindungsgemäßen Schaltungsanordnung ein Microcontroller integriert ist. Ein besonderer Vorteil desselben ist - neben der Speichermöglichkeit des ersten Fehlerfalles - auch darin zu sehen, dass unterschiedliche Schwellwerte vorgegeben werden können, um unterschiedliche Fehlerfälle zu identifizieren. Die durch diese Überwachungsschaltung verwirklichte Spannungsüberwachung der am PE-Pfad anliegenden Spannung hat sich als besonders effizient und robust erwiesen im Vergleich zu einer Überprüfung eines eventuell über den Schutzleiter fließenden Stromes.

Um die Funktionsfähigkeit der Überwachungsschaltung überprüfen zu können, weist das Überwachungsmodul in einer bevorzugten Weiterbildung einen manuell betätigbaren Unterbrecher auf, welcher zur Simulation eines unterbrochenen Schutzleiters zur temporären Unterbrechung des PE-Pfades ausgebildet ist. Der Unterbrecher ist daher nach Art eines Schalters ausgebildet, welcher die Verbindung des PE-Pfades mit dem Erdpotenzial unterbricht. Hierzu ist der Unterbrecher insbesondere im Bereich zwischen dem PE-Anschluss und den Mittenabgriff des Spannungsteilers angeordnet.

Zweckdienlicherweise weist die Auswerteeinheit weiterhin einen Prüfeingang auf, welcher über einen Prüfpfad mit dem Unterbrecher verbunden ist. Bei Betätigung des Unterbrechers wird dabei eine Verbindung des Prüfpfades mit dem Mittenabgriff des Spannungsteilers hergestellt. Durch diese Maßnahme liegt daher die Spannung am Mittenabgriff, also die PE-Spannung sowohl am PE-Eingang als auch am Prüfeingang der Auswerteeinheit an. Aufgrund der manuellen Unterbrechung durch den manuellen Unterbrecher erhöht sich üblicherweise die Spannung am Mittenabgriff, was als erster Fehlerfall identifiziert wird. Gleichzeitig wird diese Spannung auch am Prüfeingang erkannt.

Zweckdienlicherweise ist die Auswerteeinheit insbesondere über diese am Prüfeingang anliegende Spannung zur Identifizierung dieses durch den Unterbrecher ausgelösten ersten Fehlerfalls ausgebildet. In diesem Fall wird der erste Fehlerfall nicht gespeichert und es wird kein zweites Fehlersignal ausgegeben.

In zweckdienlicher Weiterbildung ist das Überwachungsmodul insgesamt auch zur Erkennung von weiteren Fehlerfällen ausgebildet. Dies ist wahlweise ein dritter Fehlerfall, bei dem am PE-Anschluss eine Spannung anliegt oder ein vierter Fehlerfall, bei dem der Phasenanschluss und der Nullanschluss verpolt ist.

Der dritte Fehlerfall tritt beispielsweise auf, wenn aufgrund einer Fehlinstallation die Phase des Versorgungsnetzes auf dem PE-Anschluss liegt. Unter bestimmten Umständen besteht hierbei die Gefahr, dass die üblichen Sicherungsmaßnahmen, wie beispielsweise Überstromschutzschalter oder auch Fehlerstromschutzschalter nicht greifen. Dieses Problem tritt aber beispielsweise auch dann auf, wenn ein Gehäuse eines elektrischen Gerätes mit dem Schutzleiter verbunden ist und gleichzeitig der Phasenleiter mit dem metallischen Gehäuse aufgrund eines Defektes oder fehlerhaften Anschlusses verbunden ist. Durch die Erkennung dieses zusätzlichen dritten Fehlerfalls wird daher ein nochmals zusätzlich verbesserter Schutz erreicht.

Alternativ oder ergänzend wird auch erkannt, ob Phasenanschluss und Nullanschluss verpolt sind, ob also die Phase des Versorgungsnetzes am Nullanschluss anliegt oder nicht. Für diesen weiteren Fehlerfall ist in der Auswerteeinheit in bevorzugter Weiterbildung ein zweiter Spannungsreferenzwert hinterlegt, bei dessen Überschreitung auf den weiteren Fehlerfall erkannt wird. Dieser zweite Spannungsreferenzwert ist dabei größer als der erste Spannungsreferenzwert. Ausgewertet wird hierbei vorzugsweise wiederum die PE-Spannung, welche am PE-Eingang des Microcontroller anliegt. Diese Ausgestaltung beruht dabei auf der Überlegung, dass in beiden Fällen, also sowohl bei einer Verpolung als auch bei einer am PE-Anschluss anliegenden Spannung der Spannungswert am Mittenabgriff deutlich höher im Vergleich zum ersten Fehlerfall liegt, so dass diese beiden weiteren Fehlerfälle eindeutig von dem ersten Fehlerfall unterschieden werden können.

Zweckdienlicherweise wird bei Erkennen des weiteren Fehlerfalls ein weiteres Fehlersignal ausgegeben, welches diesen weiteren Fehlerfall identifiziert und charakteristisch für diesen ist.

Da in der einen hier beschriebenen Ausführungsvariante eine Verpolung sowie eine am PE-Anschluss anliegende Spannung als gleicher Fehlerfall identifiziert wird, ist als erste Maßnahme durch den Benutzer ein Umpolen erforderlich, beispielsweise durch Drehen eines Steckers um 180°, um zu überprüfen, ob der weitere Fehlerfall durch eine Verpolung hervorgerufen ist. Sofern der weitere Fehler weiterhin angezeigt wird, liegt Spannung an dem PE-Anschluss an und es ist unverzüglich eine Sicherungsmaßnahme zu ergreifen.

In einer alternativen Ausgestaltung ist die Schaltungsanordnung bevorzugt derart ausgebildet, dass sie eine Verpolung erkennt, dies jedoch nicht als Fehlerfall ausgibt, sondern weiterhin überwacht, ob der Schutzleiter ordnungsgemäß angeschlossen ist. Hierzu ist die Auswerteeinheit ergänzend auch zur Überprüfung des am Phasen- oder Nullanschluss anliegenden Spannungswerts ausgebildet. Wird eine Verpolung identifiziert, so wird ein modifizierter Spannungsreferenzwert als erster Spannungsreferenzwert für die Überwachung auf den ersten Fehlerfall herangezogen. Diese Ausgestaltung beruht darauf, dass bei einer Verpolung die im Microcontroller am PE-Eingang gemessene Spannung charakteristisch verändert ist. Die Spannung am Microcontroller wird regelmäßig gegen Grundpotenzial gemessen, wobei dieses Grundpotenzial üblicherweise durch das am Nullleiter anliegende Potenzial zumindest näherungsweise definiert ist. Bei einer Verpolung ist daher das Bezugspotenzial, gegen das die Spannung am PE-Eingang ermittelt wird, ein hohes Potenzial zumindest in der Nähe der üblichen Betriebsspannung. Bei einem ordnungsgemäßen Schutzleiter und bei Verpolung wird daher am PE-Eingang eine hohe Spannungsdifferenz ermittelt. Im Falle einer Unterbrechung des PE-Leiters wird im Falle des ersten Fehlerfalls eine demgegenüber reduzierte Spannung gemessen. Der modifizierte Spannungsreferenzwert korreliert daher zu einem Spannungswert, der beispielsweise einige 10 Volt unterhalb der normalen Netzspannung liegt. Bei einer Unterschreitung des modifizierten Spannungsreferenzwerts wird dann auf den ersten Fehlerfall erkannt. Insoweit ist daher innerhalb des Überwachungsmoduls insbesondere innerhalb des Microcontrollers eine Logik implementiert, die eine Verpolung erkennt und entsprechend über den Spannungsreferenzwert für den ersten Fehlerfall eine dynamische Spannungsschwelle einstellt. Unter dynamischer Spannungsschwelle wird verstanden, dass er bei einer Verpolung auf den modifizierten Spannungsreferenzwert automatisch umschaltet.

In bevorzugter Ausgestaltung erfolgt die Spannungsversorgung der Auswerteeinheit im Normalbetrieb über die Netzspannung. Hierzu enthält also die Überwachungsschaltung ein Versorgungsmodul, welches aus der Netzspannung die Versorgungsspannung für das Überwachungsmodul, insbesondere für den Microcontroller sowie für die einzelnen Signalgeber extrahiert und bereitstellt. In zweckdienlicher Ausbildung ist dabei ergänzend noch zusätzlich eine Batterie als Notstromversorgung vorgesehen. Eine solche ist insbesondere dann erforderlich, wenn durch einen fehlerhaften Anschluss die Phase am PE-Anschluss angeschlossen ist. In diesem Fall wäre das Versorgungsmodul stromlos. Durch die zusätzliche Batterie für Notstromversorgung ist daher eine sichere Funktionsfähigkeit des Überwachungsmoduls auch in diesem speziellen Fehlerfall gewährleistet.

Für die unterschiedlichen Fehlerfälle werden unterschiedliche charakteristische Fehlersignale ausgegeben. Hierzu weist das Überwachungsmodul mehrere Signalgeber auf. Zweckdienlicherweise weist sie mehrere Signalgeber unterschiedlichen Typs auf, nämlich Lichtsignalgeber, insbesondere LED's und/oder Tonsignalgeber, wie beispielsweise einen Summer. Zweckdienlicherweise werden diese beiden unterschiedlichen Signalgeber-Typen im Fehlerfall abwechselnd angesteuert. Durch diese Maßnahme wird daher immer nur für einen Signaltyp Energie zur Verfügung gestellt, so dass der Gesamtenergieverbrauch dadurch gering gehalten ist. Zweckdienlicherweise ist dabei das Versorgungsmodul derart ausgebildet, dass hierüber nur eine geringe Leistung für die Versorgung des Überwachungsmoduls zur Verfügung gestellt wird derart, dass neben der Versorgung des Microcontrollers nur noch ein einziger Signalgeber ausreichend mit Energie versorgt wird. Im Falle eines Fehlerfalls erfolgt daher alternierend ein Umschalten zwischen Summer und LED. Die Benutzung von LED's ist aus energetischen Gesichtspunkten besonders vorteilhaft.

Das hier beschriebene Überwachungsmodul dient allgemein zur effizienten Überwachung eines Schutzleiters, ob dieser korrekt angeschlossen ist. Bevorzugt ist dabei dieses Überwachungsmodul unmittelbar in einer elektrischen Gerätekomponente integriert. Bei dieser Gerätekomponente handelt es sich in bevorzugten Alternativen um:
a) Einen Stecker zum Einstecken in einer Steckdose;
b) Einen Stromverteiler mit mehreren Steckdosen, wie beispielsweise eine Steckdosenleiste, Kabeltrommel etc.;
c) Ein separates Überwachungsmodul, welches einen Kontaktstecker zum Verbinden mit einer Steckdose aufweist. Das separate Überwachungsmodul ist dabei wahlweise, wie unter Ziff. a) erwähnt, als Stecker selbst ausgebildet, so dass das gesamte Überwachungsmodul als solches nach Art eines Plug lediglich in eine Steckdose eingesteckt zu werden braucht. Alternativ handelt es sich um eine separate Baueinheit mit eigenem Gehäuse, welches über ein Verbindungskabel mit einer Steckdose zu verbinden ist. Ein derartiges Überwachungsmodul lässt sich beispielsweise an der letzten Steckdose einer Versorgungsstrecke anschließen zur Überprüfung der gesamten Versorgungsstrecke.
d) Alternativ ist das Überwachungsmodul unmittelbar Teil eines elektrischen Haushaltsgeräts, beispielsweise der so genannten weißen Ware, wie beispielsweise Waschmaschinen, Wäschetrockner, Geschirrspüler, Kühlschränke etc., aber auch Teil vom elektrischen Kleingeräten, wie beispielsweise Wasserkocher etc.

Im Falle der Integration in einen Stromverteiler mit mehreren Steckdosen ist insbesondere vorgesehen, dass das Überwachungsmodul beispielsweise den Platz einer herkömmlichen Steckdose des Stromverteilers einnimmt und bevorzugt als ein modularer Einsatz ausgebildet ist, welcher anstelle einer Steckdose in den Stromverteiler eingesetzt ist. Bei dem Stromverteiler handelt es sich insbesondere um eine Steckdosenleiste.

Im Falle der Erkennung eines Fehlerfalls, insbesondere des ersten Fehlerfalls, wird dieser vorzugsweise lediglich angezeigt, ohne dass eine Unterbrechung der Stromversorgung automatisch veranlasst wird. In bestimmten Fällen kann jedoch auch eine automatische Unterbrechung der Stromversorgung vorgesehen sein. Eine solche ist jedoch beispielsweise bei Büroanwendungen, bei denen EDV-Geräte versorgt werden, gerade nicht gewünscht.

In einer besonders bevorzugten Ausgestaltung ist das Überwachungsmodul in einem variablen Elektrifizierungssystem insbesondere für Büros integriert. Ein derartiges variables Elektrifizierungssystem umfasst üblicherweise Steckdosenleisten, die über ein Zwischenkabel miteinander verbindbar sind. Beidendseitig am Zwischenkabel sind dabei üblicherweise Kontaktstecker angeordnet, über die die einzelnen Steckdosenleisten miteinander verbunden sind. Hierbei handelt es sich vorzugsweise um so genannte Typ SV 16-Kontaktstecker. Die Steckdosenleisten selbst weisen die handelsüblichen Stecker gemäß der jeweiligen Landesnorm für normale Haushaltsgeräte auf, in Deutschland ist dies der Schuko-Stecker. Bei einem derartigen variablen Elektrifizierungssystem ist das Überwachungsmodul beispielsweise innerhalb einer derartigen Steckdosenleiste integriert oder auch als Stecker zum Einstecken in eine (Schuko-)Steckdose einer derartigen Steckdosenleiste ausgebildet. Bevorzugt ist es jedoch als ein separates Überwachungsmodul ausgebildet, welches über ein Verbindungskabel mit einer jeweiligen Steckdosenleiste zu verbinden ist, wobei das Zwischenkabel den gleichen Typ Kontaktstecker wie das Zwischenkabel des Elektrifizierungssystems aufweist. Das Überwachungsmodul ist daher als ein Ergänzungsmodul des variablen Elektrifizierungssystem ausgebildet und lässt sich wie eine Steckdosenleiste dieses Elektrifizierungssystems als Erweiterungseinheit anschließen. Durch diese besonders vorteilhafte Ausgestaltung lässt sich dieses Überwachungsmodul in einfacher Weise an bestehende Elektrifizierungssysteme ohne Weiteres endseitig an einer letzten Steckdose anschließen. Dadurch wird der gesamte Versorgungsstrang bis zu dieser letzten Steckdose im Hinblick auf einen korrekten Schutzleiteranschluss effizient überwacht. Eine Schutzleiterüberwachung kann daher in einfacher Weise nachgerüstet werden.

Insbesondere im Hinblick auf die Ausgestaltung, bei der das Überwachungsmodul als Stecker selbst ausgebildet ist, oder auch an einem Stromverteiler angeordnet ist, ist eine kompakte Ausgestaltung erforderlich. Zweckdienlicherweise sind daher die Komponenten der Überwachungsschaltung Platz sparend in Sandwich-Bauweise ausgeführt. Hierbei ist vorgesehen, dass die einzelnen Komponenten auf zwei übereinander angeordnete Leiterplatten verteilt angeordnet sind.

Ein Ausführungsbeispiel der Erfindung wird nachfolgend anhand der Figuren näher erläutert.
- Fig. 1: ein Schaltbild einer Überwachungsschaltung eines Überwachungsmoduls zur Schutzleiter-Überwachung,
- Fig. 2: ein vereinfacht dargestelltes variables Elektrifizierungssystem mit mehreren Steckdosenleisten und einem Überwachungsmodul.

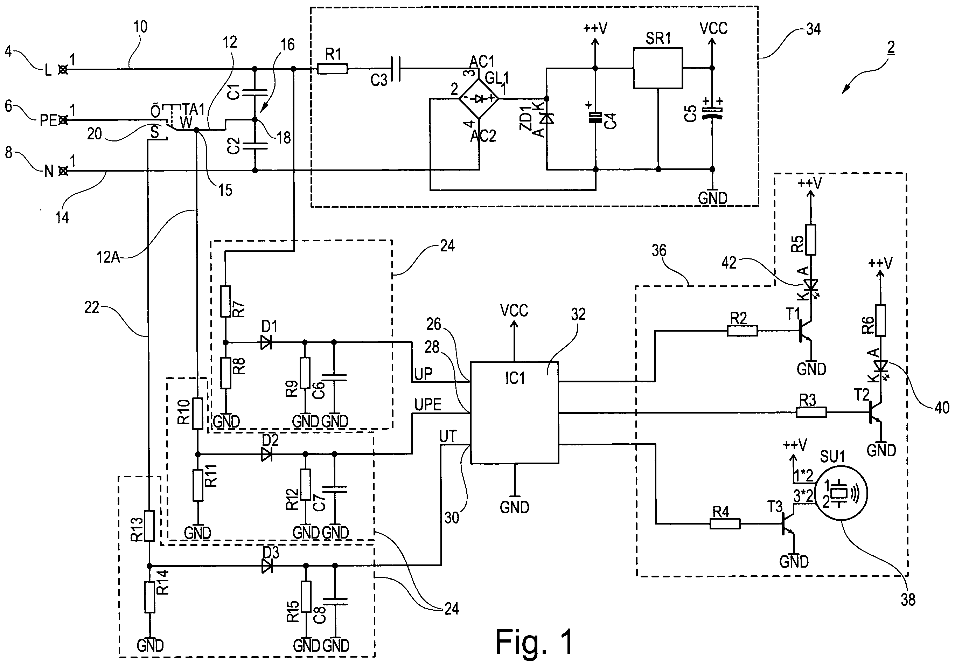

Die in Fig. 1 dargestellte Überwachungsschaltung 2 dient allgemein zur Schutzleiter-Überwachung, um zu prüfen, ob ein Schutzleiter eines Versorgungsstrangs beispielsweise für ein elektrisches Gerät unterbrochen ist. Die in der Fig.1 dargestellten Symbole entsprechen der üblichen Nomenklatur für die einzelnen Elektronik-Bausteine. Die einzelnen Elektronik-Bausteine gleichen Typs sind dabei durchnummeriert.

Die Überwachungsschaltung 2 weist eingangsseitig drei Anschlüsse, nämlich einen Phasenanschluss 4 zum Anschluss eines hier nicht näher dargestellten Phasenleiters, einen PE-Anschluss 6 zum Anschluss eines Erdungsleiters sowie einen Nullanschluss 8 zum Anschluss eines Nullleiters auf. An den jeweiligen Anschluss 4,6,8 schließt sich ein Phasenpfad 10, ein PE-Pfad 12 bzw. ein Nullpfad 14 an. Zwischen dem Phasenpfad 10 und dem Nullpfad 14 ist ein im Ausführungsbeispiel als kapazitiver Spannungsteiler angeordnet Spannungsteiler 16 mit einem Mittenabgriff 18 ausgebildet. Der PE-Anschluss ist über den PE-Pfad 12 mit diesem Mittenabgriff 18 verbunden. Dabei ist in den PE-Pfad 12 ein als Taster ausgebildeter Unterbrecher 20 eingebaut. Zwischen dem Unterbrecher 20 und dem Mittenabgriff 18 zweigt an einem PE-Abgriff 15ein Teilstück 12A des PE-Pfads 12 ab.

Beim Betätigen des Unterbrechers 20 wird der PE-Pfad 12 im Bereich des PE-Anschlusses 6 unterbrochen. Gleichzeitig wird das zum Mittenabgriff 18 orientierte Teilstück des PE-Pfades 12 mit einem Prüfpfad 22 verbunden. Bei Betätigung des Unterbrechers 20 ist der Prüfpfad 22 daher mit dem Mittenabgriff 18 verbunden.

Weiterhin wird bei Bedarf an einem Teilstück des Phasenpfades 10 nachfolgend zum Spannungsteiler 16 die am Phasenanschluss 4 anliegende Spannung abgegriffen. Diese am Phasenpfad 10 abgegriffene Spannung, die am PE-Abgriff 15 abgegriffene Spannung sowie die über den Prüfpfad 22 abgegriffene Spannung werden jeweils über ein Aufbereitungsmodul 24 aufbereitet und an einen Phaseneingang 26, einen PE-Eingang 28 bzw. einen Prüfeingang 30 eines Microcontrollers 32 zur Verfügung gestellt. In diesem ist ein in hier nicht näher dargestellter Weise Speicher integriert sowie eine Auswertelogik zur Auswertung und Beurteilung der unterschiedlichen an den Eingängen 26 - 30 anliegenden Spannungen. Dies sind eine aufbereitete Phasenspannung UP am Phaseneingang 26, eine aufbereitete PE-Spannung UPE am PE-Eingang sowie eine aufbereitete Prüfspannung UT am Prüfeingang.

Die einzelnen Aufbereitungsmodule 24 dienen zur Aufbereitung der jeweiligen Wechselspannungen für den Microcontroller 32. Die einzelnen Aufbereitungsmodule 24 weisen hierzu jeweils eingangsseitig einen Spannungsteiler (R8, R7; R11, R10; bzw. R14, R13) auf, über die der abgegriffene Spannungswert auf einen für den Microcontroller geeigneten Spannungswert reduziert wird. Ein jeweiliger Mittenabgriff dieser Spannungsteiler ist mit einer Filtereinheit verbunden, die im Ausführungsbeispiel jeweils durch eine Diode, einen Widerstand sowie einen Kondensator gebildet ist.

Der Microcontroller 32 wird über eine Versorgungsspannung VCC versorgt und misst die einzelnen Spannungen UP, UPE, UT jeweils gegen Bezugspotenzial GND. Die Versorgungsspannung VCC wird von einem Versorgungsmodul 34 der Überwachungsschaltung 2 bereitgestellt. Diese gewinnt die Versorgungsspannung VCC aus der an dem Phasenanschluss 4 bzw. bei Verpolung am Nullanschluss 8 anliegenden Netzspannung. Neben der Versorgungsspannung VCC für den Microcontroller 32 erzeugt das Versorgungsmodul 34 auch noch eine Versorgungsspannung V++ für ein Signalmodul 36. Das Versorgungsmodul 34 weist als Komponenten u.a. einen Gleichrichter GL1 sowie einen Spannungsregler SR1 auf.

Das Signalmodul 36 ist ausgangsseitig an den Microcontroller 32 angeschlossen und wird von diesem angesteuert. Es weist im Ausführungsbeispiel insgesamt drei Signalgeber, nämlich einen als Summer ausgebildeten Tongeber 38 sowie zwei Leuchtelemente, nämlich eine rote LED 40 sowie eine grüne LED 42 auf. Weitere Signalgeber sind vorzugsweise nicht vorgesehen.

Für die Überprüfung, ob ein Schutzleiter ordnungsgemäß angeschlossen ist, wird grundsätzlich vom Microcontroller 32 die PE-Spannung UPE ausgewertet und mit Spannungsreferenzwerten RE1 - RE3 verglichen. Je nachdem, in welcher Relation die gemessene PE-Spannung UPE zum Spannungsreferenzwert RE1, RE2, RE3 liegt, werden von dem Microcontroller 32 unterschiedliche Fehler F1, F2, F3, F4 identifiziert und durch eine entsprechende Ansteuerung werden am Signalmodul 36 unterschiedliche Fehlersignale S1, S2, S3 ausgegeben. Dabei werden von der Überwachungsschaltung 2 unterschiedliche Situationen und Fehler erkannt und identifiziert. Diese unterschiedlichen Betriebszustände sind in nachfolgender Tabelle zusammengefasst. Die Tabelle erhebt dabei keinen Anspruch auf Vollständigkeit. Je nach Implementierung einer geeigneten Auswertelogik im Microcontroller 32 können auch noch weitere Situationen identifiziert und ausgewertet werden.

In der Tabelle sind drei Hauptbetriebsmodi unterschieden, nämlich zunächst der Hauptbetriebsmodus "Normal", bei dem ein Phasenleiter korrekt am Phasenanschluss 4 angeschlossen ist, so dass eine (Netz-)Versorgungsspannung V am Phasenanschluss 4 anliegt. Dies ist in der Spalte "L" für den Phasenanschluss 4 durch das Symbol V für die Versorgungsspannung charakterisiert. Innerhalb des Hauptbetriebsmodus "Normal" wird unterschieden, ob der Schutzleiter korrekt angeschlossen ist, unterbrochen ist oder temporär unterbrochen war. Dies ist in der Spalte "PE" entsprechend angegeben.

Im zweiten Hauptbetriebsmodus ist in der Tabelle "Phase auf PE" angegeben, um derartige Situationen anzuzeigen, bei denen am PE-Anschluss 6 eine Spannung, insbesondere die Versorgungsspannung V anliegt. Dies ist in der Tabelle in der Spalte PE entsprechend auch durch das Symbol V gekennzeichnet.

| | **L** | **PE** | **N** | **UPE** | **Spannungsreferenzwert** | **Fehler** | **Signal** |
|---|---|---|---|---|---|---|---|
| **Normal** | | | | | | | |
| | v | i.O. | 0 | V1< RE1 | RE1 | nein | i.O. |
| | v | unterbrochen | 0 | V2 > V1>RE 1 | RE1 | F1 | S1 |
| | v | temporär unterbrochen, wieder i.O | 0 | temporär V2 > V1>R1; i.O. V1< R1 | RE1 | F2 | S2= (S1 +i.O) |

| **Phase auf PE** | | | | | | | |
|---|---|---|---|---|---|---|---|
| | V | V | 0 | V3>V2>R2 | RE2 | F3 | S3 |
| | 0 | V | 0 | V3>V2>R2 | RE2 | F3 | S3 |

| **VERPOLUNG** | | | | | | | |
|---|---|---|---|---|---|---|---|
| a) ohne Erkennung | 0 | i.O. | V | V3>V2>R2 | RE2 | F3 | S3 |
| b) mit Erkennung | 0 | i.O. | V | V3>RE3 | RE3= neuer RE1 | nein | i.O |
| | 0 | unterbrochen | V | V4 <V3<RE3 | RE3= neuer RE1 | F1 | S1 |

Schließlich ist als dritter Hauptantriebsmodus die Situation "Verpolung" angegeben. Hierbei werden zwei Varianten unterschieden wird, ob nämlich die Überwachungsschaltung 2 diese Verpolung aktiv erkennt und für die Auswertung berücksichtigt (mit Erkennung) bzw. ob sie eine solche Verpolung als Fehler F4 identifiziert (ohne Erkennung). Diese Betriebssituation "Verpolung" ist allgemein dadurch charakterisiert, dass die Versorgungsspannung V am Nullanschluss 8 anliegt. In der Tabelle ist dies in der Spalte "N" durch das Symbol V gekennzeichnet.

In der Tabelle ist in der Spalte "UPE" weiterhin angegeben, welche PE-Spannung UPE vom Microcontroller 32 ermittelt wird, und zwar in Relation zu den verschiedenen Spannungsreferenzwerten RE1, RE2, RE3. Die einzelnen PE-Spannungen UPE sind dabei als V1, V2, V3, V4 angegeben.

In der Spalte "Spannungsreferenzwert" ist schließlich angegeben, welches der jeweils aktuelle Spannungsreferenzwert ist, auf den der Microcontroller 32 zurückgreift. In der Spalte "Fehler" wird schließlich angegeben, ob und welcher Fehler F1 - F4 und in der Spalte "Signal" welches Signal S1 - S3 ausgegeben wird. Neben den Fehlersignalen S1 - S3 wird zusätzlich noch ein I.O.-Signal ausgegeben, welches durch ein Leuchten der grünen LED 42 charakterisiert ist.

Bei üblichen Installationsnetzen sind installationseingangsseitig der Nullleiter sowie der Schutzleiter auf gleichem Potenzial, sind daher miteinander verbunden. Dieses definiert zugleich das Bezugspotenzial. Abgesehen von Einkopplungseffekten liegt daher bei korrektem Anschluss der Nullanschluss 8 sowie der PE-Anschluss 6 auf zumindest annähernd gleichem Potenzial, dem Bezugspotenzial GND.

Im normalen Modus bei korrektem Anschluss liegt am PE-Abgriff 15 das Bezugspotenzial GND vor. Da der Microcontroller 32 die PE-Spannung UPE gegen Bezugspotenzial GND misst, misst er keine korrelierte Spannung bzw. allenfalls einen kleinen korrelierten Spannungswert V1. Der zugeordnete Referenzwert RE1 ist dabei sehr niedrig angesetzt und korreliert zu einem Spannungswert kleiner 10 - 20 Volt am Mittenabgriff 18. Sofern nachfolgend von korrelierten Spannungen oder Spannungswerten gesprochen wird, so berücksichtigt dies, dass an den Eingängen 28, 28, 30 des Mikrocontrollers durch die Aufbereitungsmodule reduzierte Spannungswerte im Vergleich zu den Spannungswerten an den einzelnen Abgriffen 15, 18 etc. anliegen. Wird also ein Spannungswert V1 unterhalb dieses Spannungsreferenzwerts RE1 identifiziert, so wird dies als ordnungsgemäßer Zustand interpretiert und es wird ein I.O.-Signal ausgegeben.

Ist nunmehr der PE-Leiter unterbrochen, so liegt am PE-Abgriff 15 eine Zwischenspannung zwischen der Versorgungsspannung V und dem Null-Anschluss 8 vor, die durch den Spannungsteiler 18 definiert wird und am Mittenabgriff 18 abgegriffen werden kann. Diese Zwischenspannung hat einen Spannungswert, welcher beispielsweise etwa die halbe Versorgungsspannung V ist. Am Phasenanschluss PE wird entsprechend eine deutlich erhöhte, korrelierte Spannung gemessen. In der Tabelle ist dies mit V2 charakterisiert. Da V2 nunmehr deutlich größer dem ersten Spannungsreferenzwert RE1 liegt, wird dies als erster Fehler F1 identifiziert und ein erstes Fehlersignal S1 wird ausgegeben. Dies äußert sich insbesondere durch ein abwechselndes Ansteuern der roten LED 40 sowie des Tongebers 38.

Für den Fall einer temporären Unterbrechung des Schutzleiters liegt aktuell eine I.O.-Situation vor. Der zuvor aufgetretene Fehler wird jedoch innerhalb des Microcontrollers 32 gespeichert und vorgemerkt. Dieser nur temporäre, aktuell nicht mehr vorliegende Fehlerfall wird als zweiter Fehler F2 ausgewertet und es wird ein zweites Fehlersignal S2 ausgegeben. Dieses setzt sich dabei beispielsweise aus dem normalen Fehlersignal S1 kombiniert mit dem I.O.-Fehlersignal zusammen. Speziell ist vorgesehen, dass sowohl die rote als auch die grüne LED 40,42 aktiviert sind, wobei beispielsweise die rote LED blinkt.

Für den Fall, dass am PE-Anschluss 6 Spannung anliegt, so wird als PE-Spannung UPE eine zur Versorgungsspannung V korrelierte Spannung mit dem Spannungswert V3 gemessen. Diese liegt nochmals deutlich über dem Spannungswert V2, so dass dieser Fall wiederum eindeutig zu identifizieren ist. Hierfür ist ein weiterer Spannungsreferenzwert RE2 hinterlegt, bei dessen Überschreiten auf diesen Fehlerfall F3 identifiziert wird und es wird ein entsprechendes Fehlersignal S3 ausgegeben. Dies äußert sich beispielsweise in einem schnellen Blinken der roten LED 40, kombiniert mit einem speziellen Ton über den Tongeber 38.

Die Situation, dass ein Spannungswert am PE-Anschluss anliegt, tritt beispielsweise auf, wenn ein geerdetes Gehäuse eines elektrischen Geräts mit dem Phasenleiter verbunden ist. In diesem Fall steht daher üblicherweise über den Phasenanschluss 4 weiterhin die Versorgungsspannung zur Verfügung und es ist ein ordnungsgemäßer Betrieb über das Versorgungsmodul 34 gewährleistet. Für den Fall eines falschen Anschlusses des Phasenleiters am PE-Anschluss 6 des elektrischen Gerätes weist die Überwachungsschaltung 2 weiterhin eine hier nicht näher dargestellte insbesondere wieder aufladbare Batterie auf die in diesem Fall dann die Versorgungsspannung für den Microcontroller 32 und das Signalmodul 36 bereitstellt.

Im Fall einer Verpolung liegt am Nullanschluss 8 die Versorgung V an. Bei korrektem Schutzleiteranschluss ist dieser Zustand zunächst gemäß einer ersten Ausführungsvariante nicht von der Situation unterscheidbar, bei dem am Phasenanschluss 4 die Versorgungsspannung V anliegt. Der Microcontroller 32 misst in diesem Fall das am PE-Eingang 28 anliegende Bezugspotenzial gegen die Versorgungsspannung V, so dass er wiederum den Spannungswert V3 misst. Es wird also als vierter Fehlerfall F4 der identische Fehler F3 wie zuvor beschrieben erkannt. Bei dieser Ausführungsvariante ist zur Unterscheidung zwischen den beiden Fehlerfällen F3 und F4 erforderlich, dass der Anwender beispielsweise den Stecker für das elektrische Gerät oder auch für eine Steckdosenleiste einmal um 180° dreht. In diesem Fall wird sich bei korrektem Anschluss des Schutzleiters die normale Betriebssituation einstellen und das i.O.-Signal wird erscheinen. Bleibt der Fehler bestehen, handelt es sich um einen gravierenden Fehler, der sofort zu beheben ist. Das entsprechende Fehlersignal S3 ist beispielsweise kombiniert mit einer lauten / schnellen Tonfolge.

In einer alternativen Ausführungsvariante ist eine Auswertelogik hinterlegt, welche eine derartige Verpolung erkennt. Hierzu wird beispielsweise die am Phasenanschluss 4 anliegende Spannung über den Phaseneingang 26 ausgewertet. Hierüber ist für den Microcontroller 32 erkennbar, ob eine Verpolung vorliegt oder nicht. Im Falle, dass er erkennt, dass eine Verpolung vorliegt, wird er anstelle des Spannungsreferenzwerts RE1 einen modifizierten Spannungsreferenzwert RE3 wählen. Da in diesem Fall der Microcontroller 32 die PE-Spannung UPE gegen die Versorgungsspannung V misst, liegt daher der Spannungswert V3 an. Dies korreliert in etwa zu der Versorgungsspannung V. Solange dieser oberhalb des modifizierten Referenzwerts RE3 liegt, ist der Zustand i.O.

Bei unterbrochenem Schutzleiter liegt am PE-Eingang 28 eine Zwischenspannung des Mittenabgriffs 18 an, so dass die gemessene PE-Spannung UPE im Vergleich zu V3 auf einen Wert von V4 reduziert wird, welcher unterhalb des Spannungsreferenzwerts RE3 liegt. Der Spannungsreferenzwert RE3 korreliert beispielsweise zu der Versorgungsspannung abzüglich einigen 10 Volt. Dies wird dann wiederum als erster Fehler F1 identifiziert und das erste Fehlersignal S1 wird ausgegeben.

Als eine weitere wesentliche Funktion weist die Überwachungsschaltung 2 noch eine Prüffunktion auf. Dies erfolgt durch manuelles Betätigen des Unterbrechers 20. Bei dieser Betätigung wird daher eine Unterbrechung des Schutzleiters simuliert. Dadurch wird aktiv der erste Fehler F1 herbeigeführt, welchen der Microcontroller 32 erkennt. Gleichzeitig wird jedoch durch die Verbindung über den Prüfpfad 22 mit dem Prüfeingang 30 auch an diesen Prüfeingang 30 die PE-Spannung UPE als Prüfspannung UT gemessen. Der Microcontroller 32 erkennt dadurch die Betätigung des Unterbrechers 2 und hinterlegt in diesem Fall den identifizierten Fehler F1 nicht im Speicher. Gleichzeitig gibt er ein entsprechendes Prüfsignal aus, um anzugeben, dass er funktionsfähig ist.

Die zu der Fig. 1 beschriebene Überwachungsschaltung 2 lässt sich grundsätzlich in unterschiedlichsten elektrischen Geräten zu deren Überwachung integrieren.

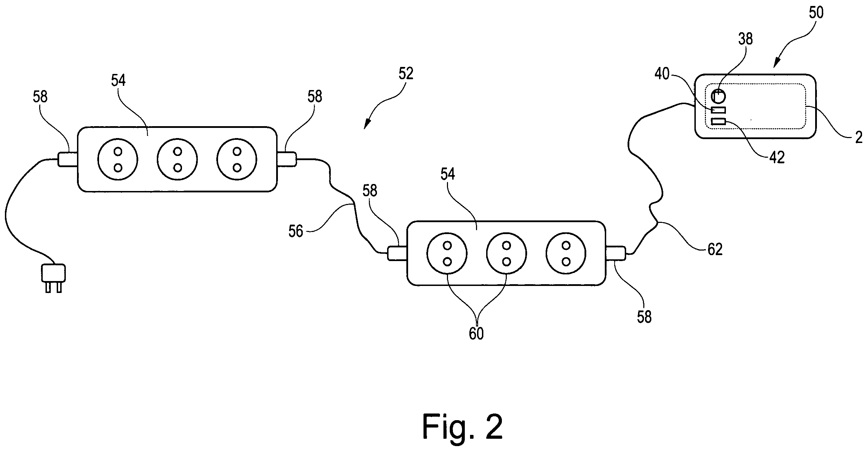

In einer besonders bevorzugten Ausgestaltung ist die Überwachungsschaltung 2 in einem eigenständigen, eine eigene Baueinheit bildendes Überwachungsmodul 50 integriert, wie dies beispielhaft in Fig. 2 anhand eines variablen Elektrifizierungssystems 52 dargestellt ist. Ein solches Elektrifizierungssystem wird üblicherweise in Büros eingesetzt und besteht üblicherweise aus einer Vielzahl von Steckdosenleisten 54, die untereinander mittels Zwischenkabel 56 verbindbar sind. Die Zwischenkabel 56 weisen dabei jeweils endseitig einen Kontaktstecker 58 auf. Jede Steckdosenleiste 54 hat daher sowohl eingangs- als auch ausgangsseitig an beispielsweise gegenüberliegenden Stirnwänden eine entsprechende Steckbuchse zur Aufnahme eines derartigen Kontaktsteckers 58. Bei diesen Kontaktsteckern 58 handelt es sich um einen von den normalen Steckdosen 60 der Steckdosenleiste 54 verschiedenen Steckertyp, beispielsweise des Typs SV18. Bei den Steckdosen 60 handelt es sich um die landesüblichen Steckdosen, in Deutschland Schuko-Steckdosen.

Das Überwachungsmodul 50 ist im Ausführungsbeispiel der Fig. 2 über ein Verbindungskabel 62 an die letzte Steckdosenleiste 54 eines Versorgungsstrangs angeschlossen. Am Verbindungskabel 62 ist hierzu wiederum ein Kontaktstecker 58 ausgebildet.

Das Überwachungsmodul 50 ist daher insgesamt gebildet durch ein Gehäuse mit der darin integrierten Überwachungsschaltung 2 sowie dem Verbindungskabel 62 mit dem endseitigen Kontaktstecker 58. Weitere Komponenten weist dieses Überwachungsmodul 50 vorzugsweise nicht auf.

Alternativ zu der in der Fig. 2 dargestellten Ausführungsvariante ist das Überwachungsmodul 50 in bevorzugter Ausgestaltung nach Art eines Steckers selbst ausgebildet, der in eine Steckdose 60 einsteckbar ist. Das gesamte Überwachungsmodul 50 ist in diesem Fall daher nach Art eines Einsteck-Plugs ausgebildet.

In einer weiteren Ausführungsvariante ist das Überwachungsmodul 50 in eine Steckdosenleiste 54 integriert. Beispielsweise nimmt es dabei den Bauraum einer der Steckdosen 60 ein.

Bei der Integration in einen Stecker ist besonders hervorzuheben, dass es sich hierbei um einen Anschlussstecker für das elektrische Gerät, beispielsweise eine Waschmaschine etc. handeln kann. In diesem Fall wird daher automatisch durch das Einstecken der Waschmaschine eine Schutzleiterüberwachung durchgeführt.

Schließlich besteht auch die Möglichkeit, dass das Überwachungsmodul 50 nach Art eines Adapters ausgebildet ist, welches einerseits zum Einstecken in eine Steckdose 60 vorgesehen ist, und gleichzeitig selbst eine Steckdose 60 ausbildet. Das Überwachungsmodul 50 lässt sich daher selbst in eine Steckdose einstecken und dient weiterhin zur Versorgung eines elektrischen Geräts.

Die einzelnen in Fig. 1 dargestellten Komponenten der Überwachungsschaltung 2 sind vorzugsweise auf zwei oder mehreren Leiterplattten verteilt angeordnet, welche übereinander in Sandwich-Bauweise zueinander platziert sind. Dies ist insbesondere bei der Integration in einen Stecker vorgesehen.

**Bezugszeichenliste**

| | | | |
|---|---|---|---|
| 2 | Überwachungsschaltung | 52 | variables Elektrifizierungssystem |
| 4 | Phasenanschluss | 54 | Steckdosenleiste |
| 6 | PE-Anschluss | 56 | Zwischenkabel |
| 8 | Nullanschluss | 58 | Kontaktstecker |
| 10 | Phasenpfad | 60 | Steckdose |
| 12 | PE-Pfad | 62 | Verbindungskabel |
| 12A | Teilstück | | |
| 14 | Nullpfad | UP | Phasenspannung |
| 15 | PE-Abgriff | UPE | UP-Spannung |
| 16 | Spannungsteiler | UT | Prüfspannung |
| 18 | Mittenabgriff | GND | Bezugspotenzial |
| 20 | Unterbrecher | RE1 | erster Spannungsreferenzwert |
| 22 | Prüfpfad | RE2 | zweiter Spannungsreferenzwert |
| 24 | Aufbereitungsmodul | RE3 | modifizierter Spannungsreferenz-wert |
| 26 | Phaseneingang | | |
| 28 | PE-Eingang | F1 | erster Fehlerfall |
| 30 | Prüfeingang | F2 | zweiter Fehlerfall |
| 32 | Microcontroller | F3 | dritter Fehlerfall |
| 34 | Versorgungsmodul | F4 | vierter Fehlerfall |
| 36 | Signalmodul | S1 | erstes Fehlersignal |
| 38 | Tongeber | S2 | zweites Fehlersignal |
| 40 | rote LED | S3 | drittes Fehlersignal |
| 42 | grüne LED | V | Versorgungsspannung |
| 50 | Überwachungsmodul | V1,V1,V3 | Spannungswerte |

## Patentansprüche

1. Überwachungsmodul (50) zur Schutzleiter-Überwachung, umfassend eine Überwachungsschaltung (2) zur Überwachung, ob ein Schutzleiter ordnungsgemäß angeschlossen ist, wobei die Überwachungsschaltung (2) bei der Detektion einer Schutzleiterunterbrechung dies als einen ersten Fehlerfall (F1) identifiziert und ein erstes Fehlersignal (S1) ausgibt,
**dadurch gekennzeichnet,**
**dass** die Überwachungsschaltung (2) zur Speicherung des ersten Fehlerfalls (F1) und weiterhin derart ausgebildet ist, dass sie im Falle einer nur temporären, nicht mehr vorliegenden Schutzleiterunterbrechung dies als einen zweiten temporären Fehlerfall (F2) identifiziert und ein zweites Fehlersignal (S2) ausgegeben wird, welches vom ersten Fehlersignal (S1) verschieden ist.

2. Überwachungsmodul (50) nach Anspruch 1,
**dadurch gekennzeichnet,**
**dass** die Überwachungsschaltung (2) derart ausgebildet ist, dass der temporäre Fehlerfall dauerhaft bis zu einem manuellen Reset gespeichert bleibt.

3. Überwachungsmodul (50) nach einem der vorhergehenden Ansprüche,
**dadurch gekennzeichnet,**
**dass** die Überwachungsschaltung (2) einen Mikrocontroller (32) zur Identifizierung zumindest des ersten Fehlerfalls (F1) umfasst.

4. Überwachungsmodul (50) nach einem der vorhergehenden Ansprüche,
**dadurch gekennzeichnet,**
**dass** die Überwachungsschaltung (2) eingangsseitig einen Phasenanschluss (4) für einen Phasenleiter mit sich daran anschließendem Phasenpfad (10), einen PE-Anschluss (6) für den zu überwachenden Schutzleiter mit einem sich daran anschließenden PE-Pfad (12) sowie einen Nullanschluss (8) für einen Nullleiter mit einem sich daran anschließenden Nullpfad (14) aufweist und die Überwachungsschaltung (2) zur Überprüfung einer am PE-Pfad (12) anliegende PE-Spannung (UPE) im Hinblick auf das Vorliegen zumindest des ersten Fehlerfalls ausgebildet ist und hierzu eine Auswerteeinheit (32) mit einem PE-Eingang (28) aufweist und die Auswerteeinheit (32) zum Vergleich der PE-Spannung (UPE) mit einem ersten Spannungsreferenzwert (RE1) ausgebildet ist, wobei hierzu insbesondere zwischen Phasenpfad (10) und Nullpfad (14) ein Spannungsteiler (16) ausgebildet ist, der PE-Pfad (12) an einem Mittenabgriff (18) des Spannungsteilers (16) angeschlossen ist und die am Mittenangriff (18) anliegende Spannung als PE-Spannung (UPE) ausgewertet wird.

5. Überwachungsmodul (50) nach einem der vorhergehenden Ansprüche,
**dadurch gekennzeichnet,**
**dass** die Überwachungsschaltung (2) zur Überprüfung der Funktionsfähigkeit einen manuell betätigbaren Unterbrecher aufweist, welcher zur Simulation eines unterbrochenen Schutzleiters zur temporären Unterbrechung des PE-Pfads ausgebildet ist.

6. Überwachungsmodul (50) nach Anspruch 4 und 5,
**dadurch gekennzeichnet,**
**dass** die Auswerteeinheit (32) einen Prüfeingang (30) aufweist, welcher mit dem Unterbrecher (20) über einen Prüfpfad (22) verbunden ist, derart, dass bei einer Betätigung des Unterbrechers (20) eine Verbindung des Prüfpfades (20) mit dem Mittenabgriff (18) hergestellt wird.

7. Überwachungsmodul (50) nach einem der vorhergehenden Ansprüche,
**dadurch gekennzeichnet,**
**dass** die Auswerteeinheit (32) derart ausgebildet ist, dass sie zwischen dem ersten Fehlerfall (F1) eines unterbrochenen Schutzleiters sowie einem weiteren Fehlerfall unterscheidet, nämlich wahlweise einem dritten Fehlerfall (F3), bei dem am PE-Anschluss (6) eine Spannung anliegt, oder einem vierten Fehlerfall (F4), bei dem der Phasenanschluss (4) und der Nullanschluss (8) verpolt sind.

8. Überwachungsmodul (50) nach Anspruch 7,
**dadurch gekennzeichnet,**
**dass** für den weiteren Fehlerfall (F3, F4) in der Auswerteeinheit (32) ein zweiter Spannungsreferenzwert (RE2) hinterlegt ist, bei dessen Überschreitung auf den weiteren Fehlerfall (F3, F4) erkannt wird, wobei der zweite Spannungsreferenzewert (RE2) größer als der erste Spannungsreferenzwert (RE1) ist.

9. Überwachungsmodul (50) nach einem der vorhergehenden Ansprüche,
**dadurch gekennzeichnet,**
**dass** die Auswerteeinheit (32) durch Überprüfung des am Phasenanschluss (4) oder Nullanschluss (8) anliegenden Spannungswertes zur Identifizierung ausgebildet ist, ob Phasenanschluss (6) und Nullanschluss (8) verpolt sind und in diesem Fall einen modifizierten Spannungsreferenzwert (RE3) als ersten Spannungsreferenzwert für die Überwachung auf den ersten Fehlerfall (F1) heranzieht.

10. Überwachungsmodul (50) nach einem der vorhergehenden Ansprüche,
**dadurch gekennzeichnet,**
**dass** die Spannungsversorgung der Auswerteeinheit im Normalbetrieb über eine Netzspannung erfolgt und zusätzlich eine Batterie als Notstromversorgung vorgesehen ist.

11. Überwachungsmodul (50) nach einem der vorhergehenden Ansprüche ,
**dadurch gekennzeichnet,**
**dass** sie mehrere Signalgeber unterschiedlichen Typs aufweist, insbesondere LED's (40,42) und/oder ein Tongeber (38) und dass im Fehlerfall diese abwechselnd angesteuert werden.

12. Überwachungsmodul (50) nach einem der vorhergehenden Ansprüche,
**dadurch gekennzeichnet,**
**dass** es in einer elektrischen Gerätekomponente integriert ist, welche wahlweise ausgebildet ist als
- Stecker zum Einstecken in eine Steckdose
- Stromverteiler mit mehreren Steckdosen,
- separates Überwachungsmodul mit einem Kontaktstecker zum Verbinden mit einer Steckdose
- elektrisches Haushaltsgerät.

13. Überwachungsmodul (50) nach Anspruch 12,
**dadurch gekennzeichnet,**
**dass** im Falle der Ausbildung als separates Überwachungsmodul dieses Teil eines variablen Elektrifizierungssystems (52) insbesondere für Büros ist, welches Steckdosenleisten (54) umfasst, die über ein Zwischenkabel (56) miteinander verbindbar sind, wobei das Zwischenkabel (56) beidendseitig einen Kontaktstecker (58) zum Anschluss an eine jeweilige Steckdosenleiste (54) aufweist, dass das separate Überwachungsmodul über ein Verbindungskabel (62) und einen Kontaktstecker (58) mit einer Steckdosenleiste (54) verbindbar ist, wobei die Kontaktstecker (58) des Zwischenkabels (56) vorzugsweise vom gleichen Typ wie der Kontaktstecker (58) des Verbindungskabels (52) ist.

14. Überwachungsmodul (50) nach einem der vorhergehenden Ansprüche,
**dadurch gekennzeichnet,**
**dass** die einzelnen Komponenten der Überwachungsschaltung (2) in Sandwich-Bauweise auf zumindest zwei übereinander angeordneten Ebenen verteilt angeordnet sind.

## Claims

1. Monitoring module (50) for protective conductor monitoring, comprising a monitoring circuit (2) for monitoring whether a protective conductor is connected properly, wherein the monitoring circuit (2), in the case of detection of a protective conductor interruption, identifies this as a first fault (F1) and emits a first error signal (S1),
**characterised in that**
the monitoring circuit (2) is formed to store the first fault (F1) and furthermore is formed in such a way that it, in the event of an only temporary protective conductor interruption which is no longer present, identifies this as a second temporary fault (F2) and emits a second error signal (S2) which is different from the first error signal (S1).

2. Monitoring module (50) according to claim 1,
**characterised in that**
the monitoring circuit (2) is formed in such a way that the temporary fault remains stored permanently until a manual reset.

3. Monitoring module (50) according to one of the preceding claims,
**characterised in that**
the monitoring circuit (2) comprises a microcontroller (32) to identify at least the first fault (F1).

4. Monitoring module (50) according to one of the preceding claims,
**characterised in that**
the monitoring circuit (2) has a phase connection (4) for a phase conductor on the input side having a phase path (10) connected thereto, a PE connection (6) for the protective conductor to be monitored having a PE path (12) connected thereto, as well as a neutral connection (8) for a neutral conductor having a neutral path (14) connected thereto, and the monitoring circuit (2) is formed to monitor a PE voltage (UPE) present at the PE path (12) with regard to the presence of at least the first fault, and for this purpose has an evaluation unit (32) having a PE input (28) and the evaluation unit (32) is formed to compare the PE voltage (UPE) with a first voltage reference value (RE1), wherein, for this purpose in particular, a voltage divider (16) is formed between the phase path (10) and the neutral path (14), the PE path (12) is connected to a centre tap (18) of the voltage divider (16) and the voltage present at the centre tap (18) is evaluated as PE voltage (UPE).

5. Monitoring module (50) according to one of the preceding claims,
**characterised in that**
the monitoring circuit (2) has an interrupter which is able to be actuated manually for monitoring functionality, said interrupter being formed to simulate an interrupted protective conductor for temporary interruption of the PE path.

6. Monitoring module (50) according to claim 4 and 5,
**characterised in that**
the evaluation unit (32) has a test input (30) which is connected to the interrupter (20) via a test path (22) in such a way that, during actuation of the interrupter (20), a connection of the test path (20) to the centre tap (18) is produced.

7. Monitoring module (50) according to one of the preceding claims,
**characterised in that**
the evaluation unit (32) is formed in such a way that it differentiates between the first fault (F1) of an interrupted protective conductor and a further fault, in particular optionally a third fault (F3), during which a voltage is present at the PE connection (6), or a fourth fault (F4), during which the phase connection (4) and the neutral connection (8) are reversed in polarity.

8. Monitoring module (50) according to claim 7,
**characterised in that**
a second voltage reference value (RE2) is deposited in the evaluation unit (32) for the further fault (F3, F4), in the case of the exceeding of which the further fault (F3, F4) is recognised, wherein the second voltage reference value (RE2) is greater than the first voltage reference value (RE1).

9. Monitoring module (50) according to one of the preceding claims,
**characterised in that**
the evaluation unit (32) is formed by checking the voltage value present at the phase connection (4) or the neutral connection (8) to identify whether the phase connection (6) and the neutral connection (8) are reversed in polarity, and in this case uses a modified voltage reference value (RE3) as a first voltage reference value for monitoring the first fault (F1).

10. Monitoring module (50) according to one of the preceding claims,
**characterised in that**
during normal operation, the voltage supply of the evaluation unit occurs via a mains voltage and a battery is additionally provided as an emergency power supply.

11. Monitoring module (50) according to one of the preceding claims,
**characterised in that**
it has several signal transmitters of a different type, in particular LEDs (40, 42) and/or a tone generator (38) and, during a fault, these are controlled alternately.

12. Monitoring module (50) according to one of the preceding claims,
**characterised in that**
it is integrated into an electrical device component which is optionally formed as
- a plug for inserting into a plug socket
- a current distributor having several plug sockets,
- a separate monitoring module having a contact plug to connect to a plug socket
- an electrical household appliance.

13. Monitoring module (50) according to claim 12,
**characterised in that**
in the event of formation as a separate monitoring module, this part of a variable electrification system (52) is in particular for offices which comprise plug socket strips (54) which are able to be connected to one another via an intermediate cable (56), wherein the intermediate cable (56) has a contact plug (58) on both sides to connect to a respective plug socket strip (54); the separate monitoring module is able to be connected to a plug socket strip (54) via a connection cable (62) and a contact plug (58), wherein the contact plug (58) of the intermediate cable (56) is preferably of the same type as the contact plug (58) of the connection cable (52).

14. Monitoring module (50) according to one of the preceding claims,
**characterised in that**
the individual components of the monitoring circuit (2) are arranged in a sandwich construction with distribution on at least two planes arranged one over the other.

## Revendications

1. Module de surveillance (50) destiné à surveiller des conducteurs de protection, comprenant un circuit de surveillance (2) destiné à surveiller si un conducteur de protection est correctement raccordé, le circuit de surveillance (2) identifiant une interruption détectée du conducteur de protection comme un premier cas d'erreur (F1) et émettant un premier signal d'erreur (S1),
**caractérisé**
**en ce que** le circuit de surveillance (2) est prévu pour mémoriser le premier cas d'erreur (F1), et en outre pour identifier une interruption du conducteur de protection seulement temporaire et n'étant plus présentée comme un deuxième cas d'erreur (F2) temporaire, et émettre un deuxième signal d'erreur (S2) différent du premier signal d'erreur (S1).

2. Module de surveillance (50) selon la revendication 1, **caractérisé**
**en ce que** le circuit de surveillance (2) est prévu de telle manière que le cas d'erreur temporaire reste mémorisé durablement jusqu'à réinitialisation manuelle.

3. Module de surveillance (50) selon l'une des revendications précédentes, **caractérisé**
**en ce que** le circuit de surveillance (2) comprend un micro-contrôleur (32) pour l'identification au moins du premier cas d'erreur (F1).

4. Module de surveillance (50) selon l'une des revendications précédentes, **caractérisé**
**en ce que** le circuit de surveillance (2) comprend côté entrée une connexion de phase (4) pour un conducteur de phase avec un chemin de phase (10) qui lui est raccordé, une connexion PE (6) pour le conducteur de protection à surveiller avec un chemin PE (12) qui lui est raccordé ainsi qu'une connexion neutre (8) pour un conducteur neutre avec un chemin neutre (14) qui lui est raccordé, et le circuit de surveillance (2) est prévu pour contrôler une tension PE (UPE) appliquée sur le chemin PE (12) relativement à la présence au moins du premier cas d'erreur, et comprend à cet effet une unité d'analyse (32) avec une entrée PE (28), et l'unité d'analyse (32) est prévue pour comparer la tension PE (UPE) à une première valeur de tension de référence (RE1), un diviseur de tension (16) étant prévu à cet effet en particulier entre le chemin de phase (10) et le chemin neutre (14), le chemin PE (12) étant relié à une prise centrale (18) du diviseur de tension (16) et la tension appliquée sur la prise centrale (18) étant évaluée comme tension PE (UPE).

5. Module de surveillance (50) selon l'une des revendications précédentes, **caractérisé**
**en ce que** pour le contrôle d'aptitude au fonctionnement, le circuit de surveillance (2) comprend un interrupteur à actionnement manuel, prévu pour la simulation d'un conducteur de protection interrompu pour l'interruption temporaire du chemin PE.

6. Module de surveillance (50) selon les revendications 4 et 5, **caractérisé**
**en ce que** l'unité d'analyse (32) présente une entrée de contrôle (30) reliée à l'interrupteur (20) par un chemin de contrôle (22), de manière à générer une connexion du chemin de contrôle (20) avec la prise centrale (18) en cas d'actionnement de l'interrupteur (20).

7. Module de surveillance (50) selon l'une des revendications précédentes, **caractérisé**
**en ce que** l'unité d'analyse (32) est prévue pour distinguer entre le premier cas d'erreur (F1) d'un conducteur de protection interrompu et un autre cas d'erreur, en l'occurrence soit un troisième cas d'erreur (F3), où une tension est appliquée sur la connexion PE (6), soit un quatrième cas d'erreur (F4), où la connexion de phase (4) et la connexion neutre (8) sont à polarités inversées.

8. Module de surveillance (50) selon la revendication 7, **caractérisé**
**en ce que** pour l'autre cas d'erreur (F3, F4) une deuxième valeur de tension de référence (RE2) est sauvegardée dans l'unité d'analyse (32), dont le dépassement est détecté comme autre cas d'erreur (F3, F4), la deuxième valeur de tension de référence (RE2) étant supérieure à la première valeur de tension de référence (RE1).

9. Module de surveillance (50) selon l'une des revendications précédentes, **caractérisé**
**en ce que** par contrôle de la valeur de tension appliquée sur la connexion de phase (4) ou la connexion neutre (8), l'unité d'analyse (32) est prévue pour identifier si la connexion de phase (6) et la connexion neutre (8) sont à polarités inversées, et à recourir dans un tel cas à une valeur de tension de référence (RE3) modifiée en tant que première valeur de tension de référence pour la surveillance de premier cas d'erreur (F1).

10. Module de surveillance (50) selon l'une des revendications précédentes, **caractérisé**
**en ce que** l'alimentation en tension de l'unité d'analyse est effectuée par une tension de secteur en service normal, et en ce qu'une batterie est prévue de manière complémentaire, comme alimentation en courant de secours.

11. Module de surveillance (50) selon l'une des revendications précédentes, **caractérisé**
**en ce qu'**il comprend plusieurs émetteurs de signaux de type différents, en particulier des LED (40,42) et/ou un émetteur sonore (38), et en ce que ceux-ci sont commandés en alternance en cas d'erreur.

12. Module de surveillance (50) selon l'une des revendications précédentes, **caractérisé**
**en ce qu'**il est intégré dans un composant d'appareil électrique, lequel est au choix réalisé comme
- connecteur à brancher dans une prise de courant,
- répartiteur de courant à plusieurs prises de courant,
- module de surveillance séparé avec une fiche de contact à brancher sur une prise de courant,
- appareil électro-ménager.

13. Module de surveillance (50) selon la revendication 12, **caractérisé**
**en ce qu'**en cas de réalisation comme module de surveillance séparé, celui-ci fait partie d'un système d'électrification (52) variable, en particulier pour des bureaux, lequel comprend des blocs multiprises (54) pouvant être reliés entre eux par un câble de liaison (56), le câble de liaison (56) présentant à ses deux extrémités une fiche de contact (58) à brancher sur un bloc multiprise (54) respectif, en ce que le module de surveillance séparé peut être raccordé par un câble de connexion (62) et une fiche de contact (58) à un bloc multiprise (54), les fiches de contact (58) du câble de liaison (56) étant préférentiellement de même type que la fiche de contact (58) du câble de connexion (52).

14. Module de surveillance (50) selon l'une des revendications précédentes, **caractérisé**
**en ce que** les différents composants du circuit de surveillance (2) sont distribués en étant disposés en sandwich sur au moins deux plans superposés.
